Europäisches Patentamt

European Patent Office

Office européen des brevets

(19)

(11) Publication number: **0 401 014**
**A2**

# EUROPEAN PATENT APPLICATION

(12)

(21) Application number: **90305926.9**

(22) Date of filing: **31.05.90**

(51) Int. Cl.⁵: **D01F 9/08**

(30) Priority: **01.06.89 US 360055**

(43) Date of publication of application:
**05.12.90 Bulletin 90/49**

(84) Designated Contracting States:
**AT CH DE FR GB IT LI NL**

(71) Applicant: **E.I. DU PONT DE NEMOURS AND COMPANY**
**1007 Market Street**
**Wilmington Delaware 19898(US)**

(72) Inventor: **Hsu, Che-Hsiung**
**4803 Mermaid Boulevard**
**Wilmington Delaware 19808(US)**
Inventor: **Tietz, Raymond**
**213 Stone Crop Road**
**Wilmington Delaware 19810(US)**

(74) Representative: **Woodman, Derek et al**
**Frank B. Dehn & Co. European Patent Attorneys Imperial House 15-19 Kingsway**
**London WC2B 6UZ(GB)**

(54) **Process for preparing superconductive fibers.**

(57) Process for preparing superconductive fiber from organic carboxylic acid solutions of carboxylic acid salts containing particulate precursor of superconductive oxide.

EP 0 401 014 A2

## Process for Preparing Superconductive Fibers

### BACKGROUND OF THE INVENTION

Superconductive compositions having the formula

$MBa_2CU_3O_x$

where M is selected from the group consisting of Y, Nd, Sm, Eu, Gd, Dy, Ho, Er, Tm, Yb and Lu, and x is from about 6.5 to 7.0 have been subjected to intensive investigation. It is expected that such compositions will find extensive use in a number of practical applications. For use in magnets and power transmission lines, it will be important that such materials be in the form of fibers (also referred to as wires) of high critical current densities ($J_c$).

Our copending European patent application no. 90301984.2 proposes a novel method for preparing superconductive fibers or wires. It involves combining of organometallic compounds of the metals in the required proportions in an organic solvent along with particulate superconductive oxides or a particulate precursor thereof and spinning into fiber. The fiber is then fired in accordance with procedures well-known in the art to produce the superconductive fiber. The present invention provides an alternate system for use with the precursor species.

### SUMMARY OF THE INVENTION

This invention provides a novel process for preparing superconductive fiber of improved critical current density and consisting of $MBa_2CU_3$ superconductive oxide where M is a metal selected from the group of Y, Nd, Sm, Eu, Gd, by, Ho, Er, Tm, Yb and Lu, comprising forming a spinnable dispersion of a particulate precursor of $MBa_2CU_3$ superconductive oxide, said precursor consisting essentially of an amorphous M compound, CuO and barium carbonate in an organic acid solution of organometallic salts of M, Ba and Cu, the atomic ratio of M:Ba:Cu in said solution being 1:2:3, forming fiber from the dispersion, and firing it to obtain a superconductive fiber.

### DETAILED DESCRIPTION OF THE INVENTION

The present invention represents a substantial improvement over the processes of the prior art such as Advanced Ceramic Mat. 3(5) 520-522 (1988), employing organometallic salts to produce superconductive fibers. The primary improved result has been obtaining fibers with high current carrying capacity, high critical current density ($J_c$), as compared with the products prepared by the prior art procedures.

Basically, the invention involves use of an organic carboxylic acid solution of metal salts of a carboxylic acid providing M, Ba and Cu in the atomic proportions 1:2:3 as the only metals. Preferably M represents yttrium, Y. The solution can comprise salts of different carboxylic acids; however, it is important that the solution be of sufficient viscosity to be spinnable, i.e., to permit extrusion through a spinneret to form fiber. Preferably, the metal salts are acetates or formates. The carboxylic acid solvent is preferably a mixture of acetic and formic acids in the ratio of 3:1 to 10:1 on a volume basis. As mentioned previously, a sufficient amount of acid mixture should be present to provide a spinnable solution. Those skilled in the art will be aware of appropriate methods to identify solutions of viscoelastic properties suitable for spinning.

To the organometallic solution is added particulate precursor of M $Ba_2Cu_3$ superconductive oxide. The metals M, Ba and Cu are in the precursor in the atomic ratio 1:2:3. The particles of precursor to be added should be chemically homogeneous and of micron to submicron size, suitable for dispersing in the carboxylic acid solution of organometallic salt and subsequent spinning. They should be present in an amount of at least 25 wt. percent, preferably between 35 and 45 wt. percent, based on total amount of particulate plus organometallic salt (without water of hydration).

A precursor found particularly useful and which has been found to give higher critical current density is prepared by blending an aqueous mixture of M acetate, preferably yttrium acetate, copper acetate and a source of barium selected from barium hydroxide and barium acetate, removing excess solvent and calcining the product in air by heating to a temperature in the range of 450°C to 750°C and maintaining that temperature for at least one hour. Precursors prepared in other ways but also consisting essentially of an amorphous compound of M, CuO and barium carbonate would also be expected to yield the desired results.

After the particulate material is dispersed, the mix is extruded through a spinneret to form fiber and the fiber is fired in an oxygen-containing atmosphere, such as air, but preferably oxygen itself to a temperature of at least 900°C as is known in the art.

The resulting fibers represent useful forms of the superconductive oxides for magnetic, power transmission or other devices.

## TEST PROCEDURES

Critical Current Density ($J_c$) is defined as the threshold current which, when passed through a given cross-sectional area of a superconductor, transforms the material from the superconductive state to the normal state. The measurement is done using a 4-probe method known in the art. A silver paste is used as electrode material to reduce contact resistance to about 5 ohm. The two inner electrodes are about 6 mm apart. While the fiber is immersed in liquid nitrogen, current is applied to the two outer electrodes. The voltage corresponding to the current applied through the two outer electrodes is measured between the two inner electrodes with an electrometer. As current is increased, at a certain point the sample is driven to the normal state. The current which flows at a voltage of 1 microvolt is defined as the threshold current. The threshold current normalized with the cross-section of the fiber sample is defined as $J_c$.

The Meissner transition is determined as follows: A measurement is made using an alternating current technique in which the change in inductance of a coil caused by flux exclusion from a sample inside the coil is measured. A signal is obtained which, after subtraction of a background empty coil voltage, is related to the amount of superconducting material in the sample volume. By making the measurement over a range of temperatures, the critical temperature of the sample and the temperature dependence of the flux exclusion can be obtained.

The following examples are illustrative of the invention and are not to be construed as limiting. EXAMPLES 2 and 3 constitute controls.

## EXAMPLE 1

A concentrated acetic/formic acid solution of yttrium, barium and copper acetate was prepared as follows: 3.42g yttrium acetate hydrate (from Research Chemicals Co., equivalent to 1.194g $Y_2O_3$ as determined by ashing), 5.36g barium acetate (Alfa #303716), 6.28g cupric acetate monohydrate (Fluka #61145), and 20 ml glacial acetic acid were placed in a 250 ml beaker. The beaker was covered with a watch glass and heated to about 60°C with constant stirring. To the warm mixture was added 6.5 ml formic acid. As soon as the formic acid was added, the mixture of acetates dissolved and the resulting solution turned dark green. The solution was heated to 75°C and held there while about 13 ml of acetic/formic acid evaporated. The concentrated solution (Solution X) was very viscous and highly extensible. Fibers with diameters less than 100 microns can be pulled from the concentrated solution with a spatula. A spinnable dispersion was made using Solution X and a superconductive oxide precursor powder.

The superconductive oxide precursor powder was prepared as follows:

(a) Copper acetate monohydrate (1.152 moles, 230.0g) was dissolved in 1.6 l of purified water at about 75°C forming a cloudy blue-green solution. To this was added a clear solution of yttrium acetate hydrate (a different lot than above supplying 0.384 moles of Y) made by dissolving 128.6g in 0.6 l of purified water at 75°C. A cloudy barium hydroxide solution (containing some white precipitate), prepared by heating 0.768 moles, 242.2g of barium hydroxide octahydrate in 0.8 l of purified water at 75°C, was added to the yttrium/copper mixture over a period of 5 minutes. The resulting brownish mixture was maintained at 75°C for 1 hour after which the water was evaporated by "spray" drying using a Buchi 190 mini spray dryer with a 0.7 mm nozzle.

(b) The dry powder from procedure (a) was calcined in air, i.e., in an oxygen-containing atmosphere, according to the following heating cycle: 100°C - 1 hr., 20°C every 5 min. to 240°C, 5°C every 10 min. to 270°C, 20°C every 5 min. to 320°C, 10°C every 10 min. to 500°C, 500°C - 1 hr., then slowly cooled to room temperature. The calcined material is an intimate and homogeneous blend of stable $BaCO_3$, $CuO$ and amorphous yttrium compounds.

(c) Seven batches treated as in (a) and (b) were hammermilled together to form a large batch. This was combined with six more batches and hammermilled to form an even larger batch from which the precursor powder for this Example was taken.

To prepare the spinnable dispersion, 8g of the superconductive-oxide precursor were added slowly to the warm (75°C) solution. The dark brown precursor and the solution formed a homogeneous almost black dispersion (compare with Example 2) which was still highly extensible. The dispersion kept at 65°C was loaded into a 20 ml plastic syringe and extruded through a nozzle onto a "Teflon"-lined cardboard. The extrudate was still very dark in color after being dried in air at room temperature (RT). This observation indicated that the added superconductive-oxide precursor had not been chemically changed.

A portion of the dried extrudate was cut into 5 cm long pieces which were placed in pure alumina boats. The alumina boats were put into a quartz container fed with oxygen at a rate of 1.0 SCFH (standard cubic feet per hour) and fired in a Fisher #497 furnace. The firing cycle was as follows: RT to 220°C at 1°C/min., 1 hr. at 220°C, 1°C/min. to 500°C, 2 hrs. at 500°C, 1°C/min. to 935°C, 2 hrs. at 935°C, cooled to 600°C at 5°C/min., 2 hrs. at 600°C, 5°C/min. to 300°C, 1 minute at 300°C, 5°C/min. to 35°C. The fired extrudate pieces were about 0.3 mm in diameter and showed a sharp Meissner transition when cooled from RT to 10°K. Magnetic flux exclusion began at 90°K and was almost complete at 77°K. Critical current density of the fired extrudate at 77°K was 594 amps/cm$^2$.

## EXAMPLE 2

This example shows that, when superconductive oxide particulate is used in place of the precursor in the dispersion, the desired result is not obtained.

YBa$_2$Cu$_3$ superconductive oxide powder was prepared as follows:

Three superconductive oxide batches (A, B and C) were combined to form one large lot by blending on a Vortac grind mill. The major phase in all three batches was determined by X-ray analysis to contain Y/Ba/Cu in a ratio of 1/2/3. Only trace amounts of other phases were found.

To prepare Batch "A", 211.8g Y$_2$O$_3$, 980.1g Ba(NO$_3$)$_2$ and 447.6g CuO were dry mixed on a Hockmeyer mixer and placed in two Coors Aluminaware trays. The mixture was calcined for 3 hours at about 970°C under an oxygen atmosphere. The temperature was lowered to 500°C and held 1 hour before cooling to room temperature. This batch was then ground in a stainless steel Waring blender.

In Batch "B" the same amounts of Y$_2$O$_3$ Ba(NO$_3$)$_2$ and CuO were mixed on the Hockmeyer using as little water as possible to form a smooth paste. The paste mixture was dried overnight at about 120°C. The dried mixture was broken up with a mortar and pestle and placed in a Coors Aluminaware tray, then calcined and cooled like Batch "A". This calcined batch was then broken up with a mortar and pestle and ground further using zirconia beads.

Batch "C" was prepared like "B" except that after calcining the batch was broken up using a stainless steel blender prior to grinding with zirconia beads.

A concentrated acetic/formic acid solution of the yttrium, barium and copper acetate was prepared according to the procedure described in EXAMPLE 1. To the viscous solution at 75°C, 8 grams of superconductive oxide powder was added slowly. The superconductive oxide did not disperse well and the mixture remained lumpy. An attempt to homogenize the mixture by stirring was not successful. The mixture was not as dark as observed in EXAMPLE 1. The black superconductive oxide slowly decomposed in the highly acidic metal acetate solution. The mixture was loaded into a 20 ml plastic syringe and extruded. The syringe nozzle repeatedly clogged and the collected extrudate pieces were uneven and short in length. They were not suitable for firing and conversion to superconductive-oxide fibers. The extrudate turned blue upon drying in air at RT. A few pieces of the extrudate were placed in water which turned blue and yielded a white precipitate. This indicates that all the superconductive oxide (which is black in color) decomposed in the highly acidic, metal acetate solution.

## EXAMPLE 3

In this example, the superconductive oxide powder particulate was added before the metal acetate was concentrated, which is different from what is described in EXAMPLE 2.

3.42g yttrium acetate, 5.37g barium acetate, 6.29g copper acetate, 20 ml glacial acetic and 6.5 ml formic acid were converted into a homogeneous solution according to the procedure described in EXAMPLE 1.

10g of the superconductive oxide powder were added slowly to the homogeneous solution and the solution concentrated at 80°C. The dispersion was not as dark as the dispersion of EXAMPLE 1. It appeared to be more like a solution than a dispersion, indicating that the added superconductive oxide had all decomposed in the acidic solution. The mixture was thickened by evaporation of acetic/formic solution and loaded into a 20 ml plastic syringe for extrusion onto a "Teflon"lined cardboard. The extrudate was blue again indicating that all added superconductive oxide had decomposed. This was verified by placing some of the extrudate in water; no black precipitate was observed in the water.

A portion of the dried extrudate was cut into small 5 cm long pieces, placed in alumina boats and fired under the same conditions as those described in EXAMPLE 1. The fired extrudate was about 0.8 mm in diameter. Test samples start to exclude magnetic flux at 90°K, but the temperature had to be reduced to 55°K before flux was completely excluded. The sample, therefore, has a wider Meissner transition than the sample described in EXAMPLE 1. The fired extrudate also had a lower critical current density (159 vs. 594 amps/cm$^2$ at 77° K).

## Claims

1. A process for preparing superconductive fiber of improved critical current density and consisting of MBa$_2$CU$_3$ superconductive oxide wherein M is a metal selected from the group consisting of Y, Nd, Sm, Eu, Gd, Dy, Ho, Er, Tm, Yb and Lu, comprising forming a spinnable dispersion of a particulate precursor of MBa$_2$CU$_3$ superconductive oxide, said precursor consisting essentially of an amorphous M compound, CuO and barium carbonate, in an organic carboxylic acid solution of carboxylic acid salts of M, Ba and Cu, the atomic ratio of M:Ba:Cu in said solution being 1:2:3, and the particulate precursor being present in the amount of at least 25 weight percent of the total amount of precursor plus carboxylic acid salt, forming fiber from the dispersion and firing it to obtain a superconductive fiber.

2. A process according to claim 1 wherein the organic acid is a mixture of acetic acid and formic acid in the ratio of 3:1 to 10:1 on a volume basis.

3. A process according to claim 1 or 2 wherein the fiber is fired in oxygen.

4. A process according to claim 1, 2 or 3 wherein M is yttrium.

5. A process according to claim 1 wherein the carboxylic acid salt is acetate or formate.